# EUROPÄISCHE PATENTSCHRIFT

(11) **EP 0 739 063 B1**
(45) Veröffentlichungstag und Bekanntmachung des Hinweises auf die Patenterteilung: **06.03.2002**
(21) Anmeldenummer: 96105971.4
(22) Anmeldetag: 17.04.1996
(51) Int. Cl.: H01R 12/18, H05K 1/18, H01R 12/20

(54) **Verbindung von Leiterplatte und Steckverbinder und damit versehene Steckkarte für elektronische Geräte**
Connection of printed board to board connector and using this connection for plug in units of electronic equipment
Fixation d'un carte de circuit imprimé à un connecteur et son utilisation pour une unité enfichable d'un équipement électronique

(30) Priorität: 20.04.1995 DE 19514121; 31.10.1995 DE 19540540
(43) Veröffentlichungstag der Anmeldung: 23.10.1996
(73) Patentinhaber: ITT MANUFACTURING ENTERPRISES, INC., Wilmington, Delaware 19801 (US)
(72) Erfinder: Learmonth, Tom, North Waltham, Basingstake, R625 26L (GB); Michaelis, Sepp-Dieter, 73431 Aalen (DE); Biermann, Werner, 73650 Winterbach (DE); Baginy, Michael, 71364 Winnenden (DE)
(74) Vertreter: Dreiss, Fuhlendorf, Steimle & Becker

(56) Entgegenhaltungen:
- FR-A- 2 404 991
- US-A- 4 423 467
- US-A- 4 628 410

## Beschreibung

Die vorliegende Erfindung bezieht sich auf eine Verbindung von Leiterplatte und Steckverbinder nach dem Oberbegriff des Anspruchs 1 und auf eine damit versehene Steckkarte für elektronische Geräte.

Bei der Verbindung von Leiterplatte und Steckverbinder ist eine lagegenaue Positionierung der beiden Bauteile relativ zueinander notwendig, da die Anschlußfahnen der Steckverbinder, bedingt durch das im allgemeinen enge Anschlußraster, auf die Anschlußbahnen der Leiterplatte zum Verlöten lagegenau kommen müssen. Diese positionsgenaue Fixierung des Steckverbinders auf der Leiterplatte oder umgekehrt wird bisher in der Weise vorgenommen, daß als Lagehalter am Steckverbinder Zapfen angeformt sind, die in Aufnahmebohrungen an den betreffenden Bereichen der Leiterplatte einsteckbar sind. Als bekannt anzusehen sind hier die sog. MPC-Stecker.

Diese Art der relativen Halterung bzw. Lagefixierung von Leiterplatte und Steckverbinder vor dem Herstellen der Lötverbindung ist relativ zeit- und kostenaufwendig in der Herstellungsvorbereitung und bezogen auf die Kontaktpositionierung zwischen den Leiterplatten-Anschlußkontaktbahnen und den Anschlußfahnen des Steckverbinders relativ ungenau.

Bekannt sind ferner Steckkarten, wie sie beispielsweise als Speicherkarten, Modemkarten, Faxkarten, oder dergleichen im PCMCIA-Standard angeboten werden, die eine derartige Verbindung aufweisen. Solche Steckkarten besitzen einen Kunststoffrahmen, auf dem ein oder zwei Steckverbinder befestigt sind und innerhalb dem die mit elektronischen Bauelementen bestückte Leiterplatte in der oben angegebenen Weise in einer fest vorgegebenen Position angeordnet und gehalten ist. Zu beiden Seiten dieses so bestückten Kunststoffrahmens sind Metalldeckel aufgebracht.

Eine weitere Verbindung von Leiterplatte und steck verbinder offenbart das Dokument US-A-4 628 410.

Aufgabe der vorliegenden Erfindung ist es, eine Verbindung von Leiterplatte und Steckverbinder und eine damit versehene Steckkarte für elektronische Geräte der jeweils eingangs genannten Art zu schaffen, bei der die positionsgenaue Fixierung von Leiterplatte und Steckverbinder herstellungstechnisch einfacher und montagetechnisch genauer möglich ist.

Zur Lösung dieser Aufgabe sind bei einer Verbindung der genannten Art die im Anspruch 1 angegebenen Merkmale vorgesehen; eine entsprechend ausgebildete Steckkarte für elektronische Geräte ergibt sich aus den Merkmalen des Anspruchs 7.

Durch die erfindungsgemäßen Maßnahmen ist die relativ ungenaue und dennoch aufwendige Anbringung von Positionsbohrungen bzw. Lochstanzungen an der Leiterplatte vermieden. Im Gegensatz dazu sind genauer zu dimensionierende und zu positionierende Lötbahnbereiche bzw. Lötpads auf der Leiterplatte vorgesehen. Dies ermöglicht ein positionsgenaueres Aneinanderbringen von Leiterplatte und Steckverbinder, und zwar dadurch, daß beim Verlöten der Lötpads der Leiterplatte mit den am Abstandelement befestigten Lötstiften die Leiterplatte sich aufgrund des flüssigen Lots zwischen den zu verlötenden Bereichen selbst schwimmend in die richtige vorgebene Position genau bringt. Darüberhinaus ist die Anbringung von Lötpads auf einer Leiterplatte einfacher und kostengünstiger als das lagegenaue Einbringen von Bohrungen in die Leiterplatte.

Bei den vorgenannten Steckkarten ist zur Ausnutzung des freien Raumes zwischen den Gehäuseteilen für mit unterschiedlich großen Bauelementen bestückten Leiterplatten vorgeschlagen worden, die Lagehalter bzw. Zapfen von einer Auflagefläche am Steckverbinder bzw. Abstandhalter aus mit stufenweise kleineren Durchmessern zu versehen, so daß sich in mehreren Ebenen im Abstand zueinander angeordnete ringförmige Auflageflächen für die Leiterplatte ergeben. Hierzu ist die Leiterplatte in den betreffenden Bereichen mit Aufnahmebohrungen versehen, deren Durchmesser in Abhängigkeit von der verwendeten bzw. bestückten Leiterplatte und damit der erwünschten Lage in der Steckkarte unterschiedlich sind. Dies bedeutet, daß eine mit durchmessergroßen Bohrungen versehene Leiterplatte vom gesamten Zapfen durchdrungen wird, so daß diese Leiterplatte die unterst mögliche Ebene in der Steckkarte einnimmt, und daß eine mit den vorgesehenen durchmesserkleinsten Bohrungen versehene Leiterplatte auf der obersten ringförmigen Auflagefläche des Zapfens aufliegt und damit die oberste mögliche Ebene einnimmt. Dabei sind ein oder mehrere Zwischengrößen an Bohrungen und damit Zwischenlagen der Leiterplatte möglich. Um auch hier eine einfachere und kostengünstigere Möglichkeit zu erreichen, sind gemäß einem bevorzugten Ausführungsbeispiel vorliegender Erfindung die Merkmale gemäß Anspruch 2 vorgesehen. Damit ist es möglich, die die Lötpads nutzende Verbindung von Leiterplatte und Steckverbinder mit der Möglichkeit der Anordnung in unterschiedlichen Ebenen zu verbinden.

Die Lötstifte können beispielsweise aus einem entsprechenden Metall sein. Zweckmäßigerweise sind jedoch gemäß dem Merkmal des Anspruchs 3 die Lötstifte aus Kunststoff und mit einem Lötpad bedruckt.

Bei einer bevorzugten Ausführungsform vorliegender Erfindung, wie sie durch die Merkmale gemäß Anspruch 4 verwirklich ist, sind die Lötstifte mit dem Steckverbinder verrastend verbindbar. Dies kann durch eine einfache Einsteckverbindung erfolgen.

Um die verschiedenen Höhenlagen bzw. Ebenen zu erreichen, können die Lötstifte beispielsweise unterschiedlich lang ausgeführt sein. Gemäß einem weiteren Ausführungsbeispiel vorliegender Erfindung sind jedoch gemäß den Merkmalen des Anspruchs 5 die Lötstifte mit mehreren im Abstand angeordneten Rastelementen versehen, so daß stets gleich ausgebildete Lötstifte verwendet werden können, die lediglich unterschiedlich weit auf bzw. in den Steckverbinder verrastet werden.

Die Lötstifte können beispielsweise als Hohlstifte auf entsprechende Zapfen am Abstandelement verrastet werden. Gemäß den Merkmalen des Anspruchs 6 ist jedoch vorgesehen, die Lötstifte in Rastbohrungen der Abstandelemente steckbar einzubringen.

Zusätzlich zu den durch die Lötstifte erreichten Auflagepunkte für die Leiterplatte können bei einer Steckkarte gemäß den Merkmalen des Anspruchs 8 zusätzliche Auflagetreppen an den Abstandelementen für Endzungen der Leiterplatte vorgesehen sein.

Weitere Einzelheiten der Erfindung sind der folgenden Beschreibung zu entnehmen, in der die Erfindung anhand der in der Zeichnung dargestellten Ausführungsbeispiele näher beschrieben und erläutert ist. Es zeigen:
- Figur 1: in schematischer perspektivischer Darstellung eine eine Verbindung von Leiterplatte und Steckverbinder gemäß einem bevorzugten Ausführungsbeispiel vorliegender Erfindung nutzende Steckkarte,
- Figuren 2A und 2B: in teilweise abgebrochener perspektivischer Darstellung einen Endbereich der Steckkarte nach Figur 1, jedoch ohne Gehäuse, in einer Schrägansicht von oben bzw. einer solchen von unten,
- Figuren 3A und 3B: einen Schnitt längs der Linie IIIA-IIIA der Figur 2A in auseinandergezogener Darstellung der einzelnen Teile bzw. eine Unteransicht gemäß Pfeil IIIB der Figur 3A,
- Figuren 4A und 4B: einen der Figur 3A entsprechenden Schnitt, jedoch in zusammengebautem Zustand bei in unterschiedlichen Ebenen innerhalb der Steckkarte gehaltener Leiterplatte, und
- Figur 5: in perspektivischer Unteransicht einen Steckverbinder für eine Verbindung mit einer Leiterplatte gemäß einem anderen Ausführungsbeispiel vorliegender Erfindung.

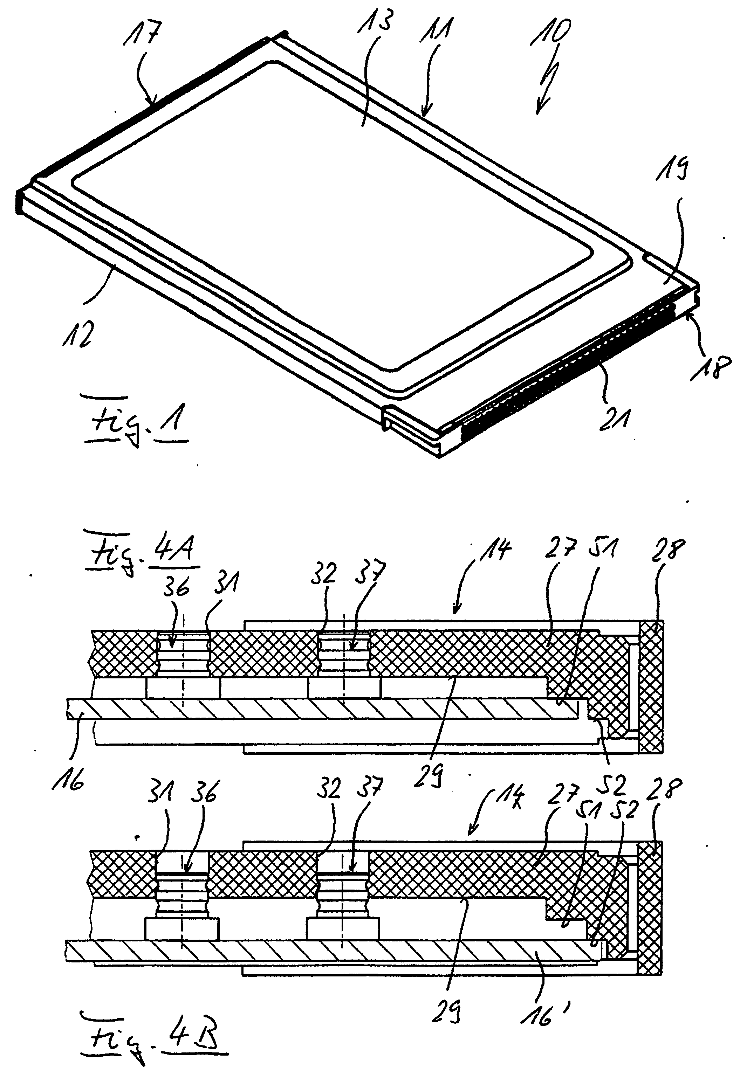

Die in Figur 1 in zusammengebautem Zustand dargestellte, eine Lötfixier-Verbindung 15 nutzende rahmenlose Steckkarte 10 für elektronische Geräte besitzt ein länglich rechteckiges und sehr flaches Gehäuse 11, das aus einem unteren Gehäuseteil 12 und einem damit verrastend verbundenen oberen Gehäuseteil 13 zusammengesetzt ist. Zwischen den beiden Gehäuseteilen 12 und 13 ist eine jeweils nur teilweise dargestellte Einheit 14 angeordnet und fixiert gehalten, die eine in nicht dargestellter Weise mit elektronischen Bauteilen bestückte, etwa länglich rechteckige Leiterplatte 16 und zwei jeweils an einem Querende der Leiterplatte 16 angeordnete und damit verbundene Abstandhalter 17 und 18 aufweist, die beide als Steckverbinder ausgebildet sind. Die beiden Steckverbinder 17 und 18 der Steckkarte 10 sind von außen zugängig, wobei beispielsweise der Steckverbinder 17 zur Aufnahme eines Kabelsteckers und das mit dem Steckverbinder 18 versehene Ende 19 der Steckkarte 10 gleichzeitig als Einsteckende für ein elektronisches Gerät ausgebildet ist. Die beiden Steckverbinder 17 und 18 besitzen jeweils einen Isolations-Formstoffkörper, in dessen Quersteg 28 in nicht näher dargestellter Weise eine Steckerbuchsenanordnung 21 vorgesehen ist, die mit jeweils einer Anschlußfahnenanordnung 22 versehen ist. Die Anschlußfahnenanordnung 22 wird in montiertem Zustand der Einheit 14 mit Anschlußkontakten 23 der Leiterplatte 16 beispielsweise durch einen Lötvorgang verbunden.

Innerhalb der Steckkarte 10 sollen Leiterplatten 16 unterschiedlicher Bestückung und damit zumindest einseitig unterschiedlicher Bauhöhe lagegerecht untergebracht werden können. Dazu sind mehrere Aufnahmepositionen in verschiedenen Ebenen innerhalb der Steckkarte 10 für jeweils eine bestimmte Leiterplatte 16 vorgesehen.

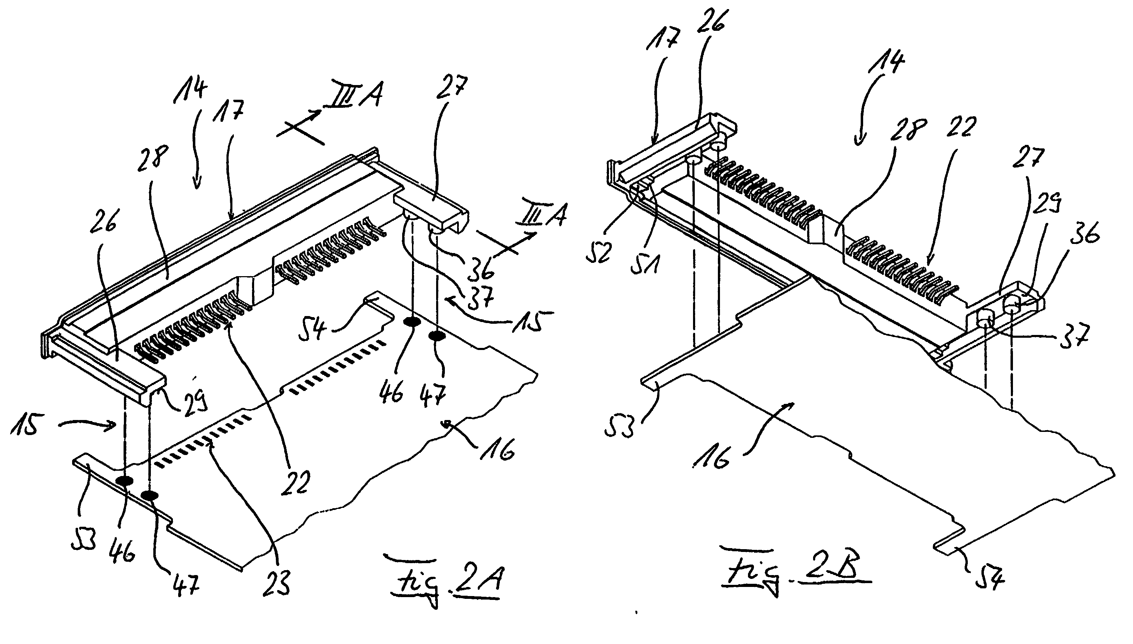

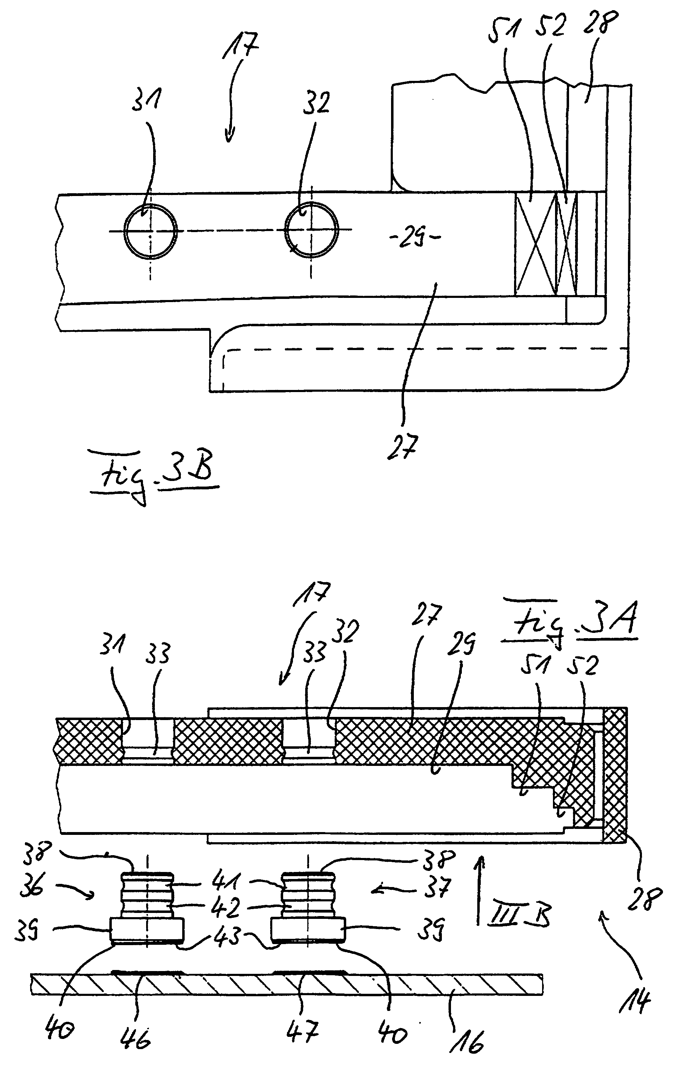

Gemäß den Figuren 3A und 3B besitzt, wie hier lediglich anhand des Abstandhalters 17 dargestellt, jeder der als Steckverbinder ausgebildete Abstandhalter 17 und 18 seitliche längsverlaufende Stege 26 und 27, die die Tiefe des mit der Steckerbuchsenanordnung 21 und der Anschlußfahnenanordnung 22 versehenen Quersteges 28 überragen. Die beiden Längsstege 26 und 27 besitzen an einem inneren Bereich und im Abstand voneinander Aufnahmebohrungen 31 und 32, die an einem der Unterseite 29 der Längsstege 26, 27 zugewandten Bereich mit einem angeformten nach innen ragenden und damit den Durchmesser verkleinernden Ringwulst 33, der einen konvexen Querschnitt aufweist, versehen ist.

Gemäß Figur 3A sind zur Herstellung der Verbindung 15 ferner identisch ausgebildete Lötstifte 36 und 37 vorgesehen, die einstückig einen Schaft 38 und einen durchmessergrößeren flachen scheibenartigen Kopf 39 aufweisen. Der Schaft 38 ist mit mehreren, beispielsweise zwei, in axialem Abstand voneinander angeordneten Ringkerben 41 und 42, die einen konkaven Querschnitt aufweisen, versehen. Der Durchmesser des Schaftes 38 und die Ausbildung der Ringkerben 41 und 42 ist derart, daß der Schaft 38 der Lötstifte 36 und 37 in die Aufnahmebohrung 31 bzw. 32 des Steckverbinders 17, 18 verrastend paßt. Dabei bildet der Ringwulst 33 das eine Rastelement, während jeweils eine der Ringkerben 41, 42 das andere Rastelement bildet. Beim dargestellten Ausführungsbeispiel kann entweder die in Einsteckrichtung vordere Ringkerbe 41 oder die in Einsteckrichtung hintere Ringkerbe 42 mit dem Ringwulst 33 verrasten, so daß der Kopf 39 des Lötstiftes 36, 37 einen unterschiedlichen, vorgegebenen Abstand von der Unterseite 29 der Längsstege 26, 27 des Steckverbinders 17, 18 besitzt. Der Kopf 39 ist an seiner dem Schaft 38 abgewandten Stirnfläche 43 dann, wenn der Lötstift 36, 37 aus einem Kunststoff besteht, mit einem Lötpad 40, das vorzugsweise ganzflächig sich auf der Stirnfläche 43 befindet, versehen.

Die Leiterplatte 16 ist außer mit den Anschlußkontakten 23 und mit nicht dargestellten Lötbahnen für die betreffenden Bauteile ferner an ihrer der Unterseite 29 des Steckverbinders 17, 18 zugewandten Fläche mit Lötpads 46, 47 versehen, die an Stellen angeordnet sind, die in montiertem Zustand der Stirnfläche 43 des Kopfes 39 der Lötstifte 36, 37 bzw. deren Lötpads 40 gegenüberliegen.

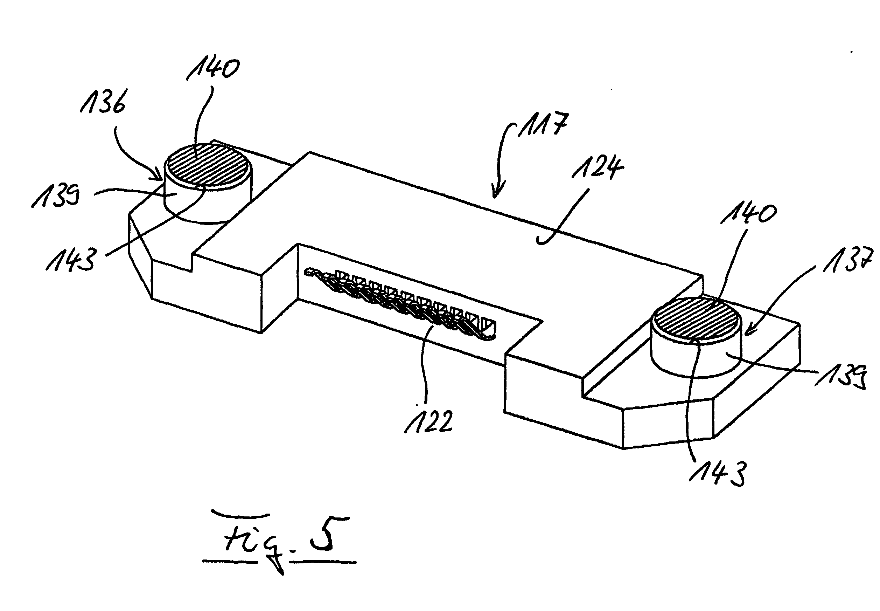

Gemäß den Figuren 4A und 4B kann eine Leiterplatte 16 bzw. 16' in unterschiedlichen Ebenen innerhalb der Steckkarte 10 an den Steckverbindern 17, 18 gehalten sein. Figur 4A zeigt eine der Unterseite 29 der Steckverbinder 17, 18 nahe Anordnung der Leiterplatte 16. Diese wird dadurch erreicht, daß die Lötstifte 36, 37 vollständig in die Aufnahmebohrung 31, 32 eingesteckt sind, in welcher Position die in Einsteckrichtung hintere Ringkerbe 42 der Lötstifte 36, 37 mit dem Ringwulst 33 der Aufnahmebohrungen 31, 32 verrastet sind. In dieser Rastposition der Lötstifte 36, 37 wird die Leiterplatte 16 aufgelegt, wobei durch einen Lötvorgang, mit dessen Hilfe weitere Lötverbindungen vorgenommen werden können, die Lötpads 46, 47 an der Leiterplatte 16 mit dem Lötpad 40 des Kopfes 39 der Lötstifte 36, 37 lötend verbunden werden. Durch das zwischen den einander gegenüberliegenden Lötpads 46, 47 und 40 verflüssigte Lot wird die Leiterplatte 16 sozusagen schwimmend an die Lage der an den Steckverbindern 17, 18 gehaltenen Lötstifte 36, 37 angepaßt.

Entsprechendes gilt für die von der Unterseite 29 der Steckverbinder 17, 18 weiter entfernte Lage einer Leiterplatte 16', die dadurch entsteht, daß die in Einsteckrichtung vordere Ringkerbe 41 der Lötstifte 36, 37 mit dem Ringwulst 33 der Aufnahmebohrungen 31, 32 verrastet. Die Lötverbindung der Leiterplatte 16' an den Lötstiften 36, 37 erfolgt in vorbeschriebener Weise.

Es versteht sich, daß der oder die Lötstifte 36, 37 mehr als zwei Rastelemente, d.h. Ringkerben in axialem Abstand besitzen kann bzw. können. Es versteht sich außerdem, daß die Lötstifte 36, 37 aus einem für den Lötvorgang geeigneten Metall bestehen können. Desweiteren kann auf diese Weise auch mehr als eine Leiterplatte 16, 16' innerhalb der Steckkarte 10 angeordnet werden.

Zur weiteren Abstützung der Leiterplatte 16 auf den Steckverbindern 17 und 18 sind gemäß der zeichnerischen Darstellung die Steckverbinder 17, 18 an Bereichen der Längsstege 26, 27, die dem Quersteg 28 benachbart sind, mit treppenartigen Stufen 51, 52 versehen, die sich in ebener Flucht mit der Stirnfläche 43 der Lötstifte 36, 37 in einer der beiden Raststellungen befinden und auf denen seitliche leistenartige Verlängerungen 53 und 54 der Leiterplatte 16 bzw. 16' liegen. Je nach ausgewählter Position der Leiterplatte 16, 16' innerhalb der Steckkarte 10 sind die Verlängerungen 53, 54 der Leiterplatte 16 bzw. 16' in ihrer Länge an die betreffende Stufe 51, 52 angepaßt. Es versteht sich, daß die Anzahl der Stufen 51, 52 der Anzahl der Rast- bzw. Ringkerben 41, 42 der Lötstifte 36, 37 angepaßt ist.

Figur 5 zeigt einen Steckverbinder 117, der in der zum ersten Ausführungsbeispiel gemäß den Figuren 1 bis 4 dargestellten Weise über die Verbindung 15 mit einer in dieser Figur nicht dargestellten Leiterplatte verbunden werden kann. Der Steckverbinder 117, der mit einer über seine Unterseite 124 vorstehende Anschlußfahnenanordnung 122 versehen ist, die in vorstehend beschriebener Weise mit Anschlußbahnen an einer Leiterplatte mittels Löten zu verbinden ist, ist zu beiden Seiten der Anschlußfahnenanordnung 122 mit jeweils einem Lötstift 136 bzw. 137 bestückt, von dem jeweils lediglich der flache scheibenartige Kopf 139 zu sehen ist, auf dessen Stirnfläche 143 sich ein Lötpad 140 vorzugsweise ganzflächig befindet. Diesen Lötpads 140 des Steckverbinders 117 gegenüberliegend sind Lötpads an Stellen einer Leiterplatte angeordnet, die in montiertem Zustand der Lage der Stirnfläche 143 des Kopfes 139 der beiden Lötstifte 136 und 137 entsprechen, wie dies anhand des ersten Ausführungsbeispieles der Figuren 1 bis 4 beschrieben ist. Es versteht sich, daß die Stirnflächen 143 der Lötstifte 136 und 137 in einer der Lage der Anschlußfahnenanordnung 122 entsprechenden Weise über die Unterseite 124 des Steckverbinders 117 vorstehen und daß die Anschlußfahnenanordnung 122 und die Stirnflächen 143 bzw. die Lötpads 140 der Lötstifte 136 und 137 in im wesentlichen derselben Ebene gemäß Figur 5 oberhalb der Unterseite 124 des Abstandhalters 117 angeordnet sind.

Auch bei einem derartigen, hier als sog. MPC-Stecker ausgebildeten Steckverbinder 117 ist es entsprechend dem Ausführungsbeispiel der Figuren 1 bis 4 möglich, die Lötstifte 136 und 137 in unterschiedliche Höhenlagen am Steckverbinder 117 verrastend verbindbar vorzusehen. Außerdem kann wie beim ersten Ausführungsbeispiel auf jeder Seite des Steckverbinders 117 mehr als ein Lötstift 136 bzw. 137 vorgesehen sein.

Es versteht sich, daß auch andere Steckverbinderarten über eine derartige erfindungsgemäße Verbindung 15 an einer Leiterplatte positionsgenau fixierbar sein können.

## Patentansprüche

1. Verbindung (15) von Leiterplatte und Steckverbinder, bei der eine mit Anschlußbahnen versehene Leiterplatte (16) und ein mit Anschlußfahnen versehener Steckverbinder (17, 18; 117) mittels am Steckverbinder vorgesehener Lagehalter (36, 37; 136, 137) relativ zueinander positionsgenau fixierbar sind, **dadurch gekennzeichnet, daß** die Lagehalter durch von den Anschlußfahnen getrennt angeordnete Lötstifte (36, 37; 136, 137) gebildet sind, und daß auf der Leiterplatte (16) von den Anschlußbahnen getrennt angeordnete Lötpads (46, 47) vorgesehen sind, die mit den gegenüberliegenden Lötstiften (36, 37; 136, 137) lötend verbindbar sind.

2. Verbindung nach Anspruch 1, **dadurch gekennzeichnet, daß** die Lötstifte in unterschiedlichen Höhenlagen am Steckverbinder (17, 18; 117) befestigbar sind.

3. Verbindung nach Anspruch 1 oder 2, **dadurch gekennzeichnet, daß** die Lötstifte (36, 37; 136, 137) aus Kunststoff und mit einem Lötpad (40; 140) bedruckt sind.

4. Verbindung nach Anspruch 2 oder 3, **dadurch gekennzeichnet, daß** die Lötstifte (36, 37; 136, 137) mit dem Steckverbinder (17, 18; 117) verrastend verbindbar sind.

5. Verbindung nach Anspruch 4, **dadurch gekennzeichnet, daß** die Lötstifte (36, 37) mehrere im Abstand angeordnete Rastelemente (41, 42) aufweisen.

6. Verbindung nach Anspruch 4 oder 5, **dadurch gekennzeichnet, daß** die Lötstifte (36, 37) in Rastbohrungen (31, 32) des Steckverbinders (17, 18) steckbar sind.

7. Mit einer Verbindung (15) nach einem der vorhergehenden Ansprüche versehene Steckkarte (10) für elektronische Geräte in etwa länglich rechteckiger, flächiger Form, mit einem zwei halbschalenartig ausgebildete Gehäuseteile (12, 13) aufweisenden Gehäuse (11) und mit einem vorzugsweise an jeder Gehäusequerseite gehaltenen Steckverbinder, der als Abstandelement (17, 18) ausgebildet ist.

8. Steckkarte nach Anspruch 7, **dadurch gekennzeichnet, daß** die beidendig vorgesehenen Steckverbinder (17, 18), den Lötstiften (36, 37) benachbart, deren Höhenlagen entsprechende Auflagestufen (51, 52) aufweisen.

## Claims

1. Connection (15) of printed circuit board and plug connector, in which a printed circuit board (16) provided with terminal paths and a plug connector (17, 18; 117) provided with terminal lugs can be fixed in the correct relative position to one another by means of position-holding devices (36, 37; 136, 137) provided on the plug connector, **characterised in that** the position-holding devices are formed by soldering pins (36, 37; 136, 137) arranged separately from the terminal lugs, and **in that** soldering pads (46, 47) arranged separately from the terminal tracks are provided on the printed circuit board (16), which soldering pads (46, 47) can be soldered to the opposing soldering pins (36, 37; 136, 137).

2. Connection according to claim 1, **characterised in that** the soldering pins can be fastened at various heights to the plug connector (17, 18; 117).

3. Connection according to claim 1 or 2, **characterised in that** the soldering pins (36, 37; 136, 137) are made of plastics material and are imprinted with a soldering pad (40; 140).

4. Connection according to claim 2 or 3, **characterised in that** the soldering pins (36, 37; 136, 137) can be connected to the plug connector (17, 18; 117) so as to latch.

5. Connection according to claim 4, **characterised in that** the soldering pins (36, 37) have a plurality of latching elements (41, 42) arranged at a distance.

6. Connection according to claim 4 or 5, **characterised in that** the soldering pins (36, 37) can be inserted in latching holes (31, 32) of the plug connector (17, 18).

7. Plug-in card (10) provided with a connection (15) according to any one of the preceding claims, for electronic devices of substantially elongated rectangular, plane shape, with a housing (11) comprising two shell-like housing parts (12, 13) and with a plug connector, which is designed as a spacing element (17, 18), preferably held on each transverse side of the housing.

8. Plug-in card according to claim 7, **characterised in that** the plug connector (17, 18) provided at both ends, is adjacent to the soldering pins (36, 37), the heights of which comprise corresponding support steps (51, 52).

## Revendications

1. Dispositif de fixation d'une plaque de circuit imprimé à un connecteur enfichable, dans laquelle une plaque de circuit imprimé (16) munie de bandes de connexion et un connecteur (17, 18 ; 117) muni de broches de connexion peuvent être fixés relativement l'un sur l'autre avec exactitude de position au moyen de dispositifs de maintien en position (36, 37 ; 136, 137), **caractérisée en ce que** les dispositifs de maintien en position sont constitués par des pointes de soudure (36, 37 ; 136, 137) séparées des bandes de connexion et **en ce que** l'on prévoit, sur la plaque de circuit imprimé (16), des bourrelets de soudure (46, 47) qui sont séparés des bandes de connexion et qui peuvent être fixés par soudage sur les pointes de soudure (36, 37 ; 136, 137) qui leur font face.

2. Dispositif de fixation selon la revendication 1, **caractérisée en ce que** les pointes de soudure peuvent être fixés à des positions différentes en hauteur sur le connecteur (17, 18 ; 117).

3. Dispositif de fixation selon la revendication 1 ou 2, **caractérisée en ce que** les pointes de soudure (36, 37 ; 136, 137) sont en matière synthétique et comportent une impression avec un bourrelet de soudure (40, 140).

4. Dispositif de fixation selon la revendication 2 ou 3, **caractérisée en ce que** les pointes de soudure (36, 37 ; 136, 137) peuvent être fixées avec encliquetage sur le connecteur (17, 18 ; 117).

5. Dispositif de fixation selon la revendication 4, **caractérisée en ce que** les pointes de soudure (36, 37) comportent plusieurs éléments d'encliquetage (41, 42) disposés à distance les uns des autres.

6. Dispositif de fixation selon la revendication 4 ou 5, **caractérisée en ce que** les pointes de soudure (36, 37) peuvent être enfichées dans des perçages d'encliquetage (31, 32) du connecteur (17, 18).

7. Carte enfichable (10) destinée à des appareils électroniques et équipée d'un dispositif de fixation (15) selon l'une quelconque des revendications précédentes, ayant sensiblement la forme plate d'un rectangle allongé et comportant un boîtier (11) comprenant deux parties de boîtier (12, 13) réalisées sous la forme de demi-coquilles et un connecteur qui est maintenu, de préférence, sur chaque côté transversal du boîtier et qui est réalisé sous la forme d'un élément d'écartement (17, 18).

8. Carte enfichable selon la revendication 7, **caractérisée en ce que** les deux connecteurs (17, 18) prévus aux deux extrémités comportent des gradins d'appui (51, 52) qui sont disposés au voisinage des bourrelets de soudure (36, 37) et à des positions en hauteur en correspondance avec les gradins d'appui.
